# EUROPEAN PATENT APPLICATION

(11) **EP 3 098 836 A1**
(43) Date of publication of application: **30.11.2016**
(21) Application number: 16168666.2
(22) Date of filing: 06.05.2016
(51) Int. Cl.: H01L 21/20, H01L 21/762

(54) **LOW TEMPERATURE WAFER BONDING**

(30) Priority: 27.05.2015 US 201514722910
(71) Applicant: Honeywell International Inc., Morris Plains, NJ 07950 (US)
(72) Inventor: ENDEAN, Daniel, Morris Plains, NJ New Jersey 07950 (US); MARTIN, Robert R., Morris Plains, NJ New Jersey 07950 (US); HORNING, Robert D., Morris Plains, NJ New Jersey 07950 (US)
(74) Representative: Houghton, Mark Phillip

(57) **Abstract**

A method of low temperature wafer bonding is provided. The method comprises: providing oxide to form a bonding layer on a deposition surface of at least one of two wafers, the bonding layer having a thickness in the range of 100 Angstroms to 500 Angstroms; soaking the wafers in a solution that makes bonding surfaces of the wafers hydrophilic; rinsing the wafers with water after soaking the wafers in the solution that makes bonding surfaces of the wafers hydrophilic; drying the wafers; optical-contact bonding the wafers with each other by bringing the bonding layers of the wafers in contact with each other to form a wafer pair; and annealing the wafer pair at a temperature less than or equal to 500° Celsius.

## Description

### BACKGROUND

Standard wafer bonding involves an annealing step at high temperatures (greater than 500° Celsius) to convert a weak bond into a stronger bond. This process involves performing a surface treatment on two wafers, bringing the wafers into contact, and then annealing the wafers at high temperatures so that they are permanently fused together. If the annealing step is performed after the fabrication of the device on the wafers, the high temperatures may harm the metallic components of the device. Further, when two wafers of different materials are bonded together at high temperatures, the materials will expand at a different rate due to the difference in the coefficient of thermal expansion (CTE) of the two materials and the bond may break.

Using conventional processes, if the wafers are not annealed at a high temperature, the wafers will not fuse together completely because of bubbles that are formed in the bonding interface. These bubbles are caused by small amounts of gas that evolve out of the wafer surfaces at lower temperatures. The gas is dissolved into the wafer surfaces when heated at high temperatures. At low temperatures, the bubbles remain undissolved and weaken the bond between the two wafers.

Ultra high vacuum (UHV) bonding, adhesive layered bonding, low vacuum bonding, and plasma treatment prior to bonding are some of the conventional techniques utilized to achieve strong bonds at the bonding interface using lower temperature anneals (less than 500° Celsius). Some of these techniques require special surface activation steps such as exposure to plasma or annealing unbonded wafers after dipping in hydrogen fluoride (HF) solution. Some of the techniques further require depositing a thick layer of oxide material followed by aggressive chemical mechanical polishing/planarization (CMP) process to achieve a smooth bonding interface.

For the reasons state above and for other reasons stated below, it will become apparent to those skilled in the art upon reading and understanding the specification, there is a need in the art for improved systems and methods for wafer bonding at low temperatures (less than 500° Celsius).

### SUMMARY

In one embodiment, a method of low temperature wafer bonding, comprises: providing oxide to form a bonding layer on a deposition surface of at least one of two wafers, the bonding layer having a thickness in the range of 100 Angstroms to 500 Angstroms; soaking the wafers in a solution that makes bonding surfaces of the wafers hydrophilic; rinsing the wafers with water after soaking the wafers in the solution that makes bonding surfaces of the wafers hydrophilic; drying the wafers; optical-contact bonding the wafers with each other by bringing the bonding layers of the wafers in contact with each other to form a wafer pair; and annealing the wafer pair at a temperature less than or equal to 500° Celsius.

### DRAWINGS

Understanding that the drawings depict only exemplary embodiments and are not therefore to be considered limiting in scope, the exemplary embodiments will be described with additional specificity and detail through the use of the accompanying drawings, in which:
Figures 1A-1E are cross-sectional side views of various stages in an example bonding process for two wafers.
Figure 2 is a flow diagram for one embodiment of a method of low temperature bonding for two wafers.

In accordance with common practice, the various described features are not drawn to scale but are drawn to emphasize specific features relevant to the exemplary embodiments.

### DETAILED DESCRIPTION

In the following detailed description, reference is made to the accompanying drawings that form a part hereof, and in which is shown by way of illustration specific illustrative embodiments. However, it is to be understood that other embodiments may be utilized and that logical, mechanical, and electrical changes may be made. Furthermore, the method presented in the drawing figures and the specification is not to be construed as limiting the order in which the individual steps may be performed.

Embodiments of the present disclosure provide a strong bond between two wafers at low temperatures (less than 500° Celsius) by introducing a thin layer of oxide at the bonding interface. A strong bond can be achieved in an efficient manner by depositing a thin layer of oxide on the bonding surfaces of two smooth wafers without extensive steps involving any polishing or planarization of the oxide. In some implementations, the bond between the two wafers is hermetic. The strength of the bond provided by the methods described herein is at least 2.5 J/m². In some implementations, the strength of the bond is determined using a standard razor blade test. The thin layer of oxide comprised in the bonding interface ranges from 100 Angstroms to 1000 Angstroms inclusive. Further, no special surface activation steps such as exposure to plasma or annealing unbonded wafers after dipping in an HF solution are required.

In some implementations, the two wafers used in the low temperature bonding processes and systems described herein are composed of different materials (ex. silicon to sapphire bond). Because the wafers are bonded at low temperatures (less than 500°C), the difference in CTE of the two materials does not affect the durability of the bond between the two wafers. In other implementations, both the wafers are composed of the same material. In some implementations, one or both the wafers are composed of silicon. The embodiments provided herein can be used in various technologies including applications in microelectronics, accelerometers, gyroscopes, or pressure sensors.

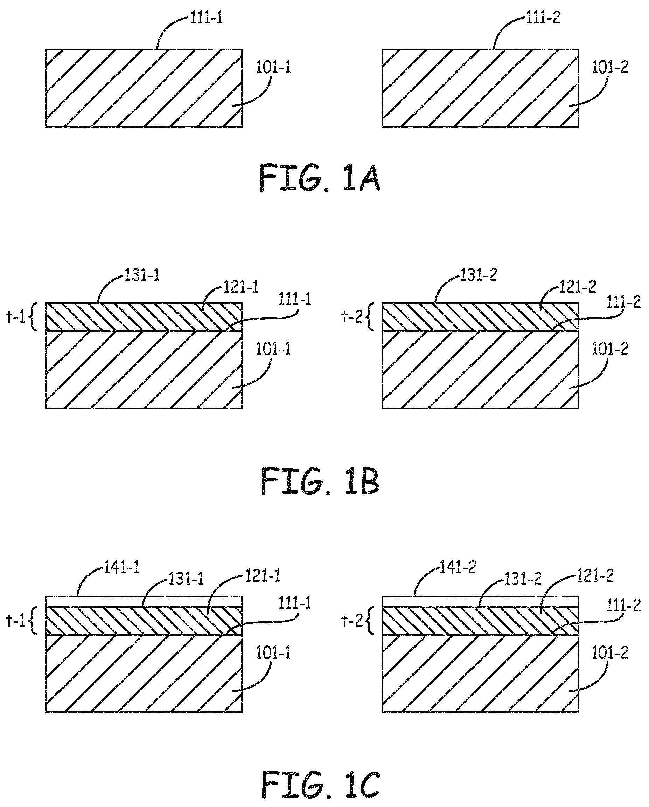

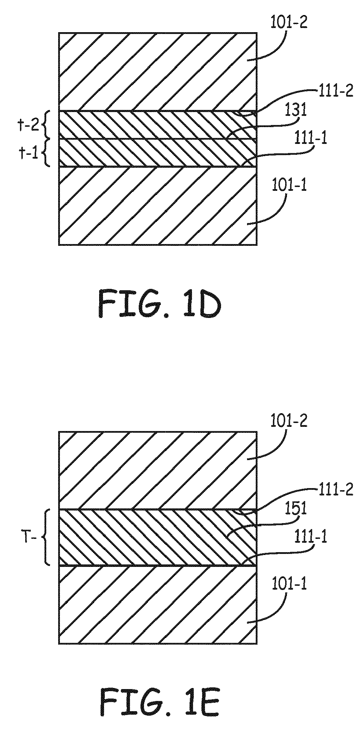

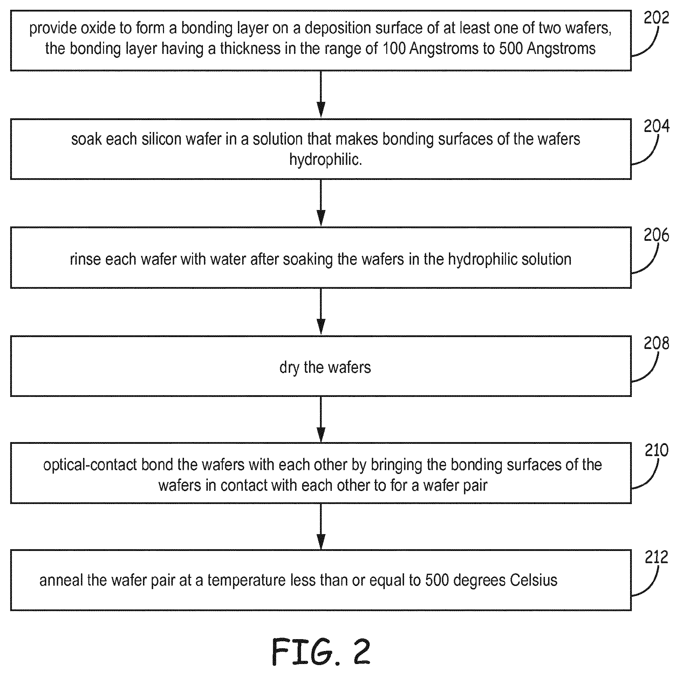

Figures 1A-1E illustrate various stages in an example process of wafer bonding at low temperatures. Figure 2 is a flow diagram of the example process. The bonding process begins with at least two smooth bare wafers 101-1 and 101-2.

The example in Figure 1A shows a first bare wafer 101-1 and a second bare wafer 101-2. Wafers 101-1 and 101-2 have smooth deposition surfaces 111-1 and 111-2 respectively. Deposition surfaces 111-1 and 112-2 have a root-mean square (RMS) surface roughness within the range of 0.1 nanometers to 3 nanometers. In some implementations, wafers 101-1 and 101-2 are cleaned using a standard piranha solution. Piranha solution typically comprises a mixture of hydrogen peroxide and sulfuric acid. In one implementation, the wafers are cleaned for at least 10 minutes in a 1:1 hydrogen peroxide and sulfuric acid solution (1:1 H₂O₂ : H₂SO₄). In other implementations, the ratio of hydrogen peroxide to sulfuric acid is different. In a further implementation, wafers 101-1 and 101-2 are rinsed with water and then dried.

The next step in the process comprises forming a thin layer of oxide 121 on one or both of the wafer surfaces. In the example shown in Figure 1B, a thin oxide layer 121-1 and 121-2 is depicted on both surfaces 111-1 and 111-2, respectively. In conventional bonding processes, small amounts of gas evolves out of the wafer surfaces at lower temperatures, creating bubbles at the bond interface. When the wafers are heated at high temperatures, the gas is dissolved back into the wafer surfaces, eliminating the bubbles. However, when the wafers are bonded at low temperatures (less than 500° Celsius) these bubbles remain and the wafers do not completely fuse together. A thin layer of oxide at the bonding allows a more complete bonding of the wafers at lower temperatures, without gaps.

As shown in block 202 of Figure 2, a bonding layer is formed by providing oxide on one or both the deposition surfaces 111-1 and 111-2. The thickness of the bonding layer ranges from 100 to 500 Angstroms inclusive. Figure 1B depicts an example where bonding layer 121-1 is formed on deposition surface 111-1 and bonding layer 121-2 is formed on deposition surface 111-2. However, in other embodiments, the bonding layer may be formed on only one of the two deposition surfaces 111-1 or 111-2. In one implementation, the oxide provided on one or both of the deposition surfaces is silicon oxide. This bonding layer of oxide is formed without any polishing or planarization of the oxide. In one implementation, providing oxide to form a bonding layer comprises forming an oxide layer on each of the deposition surfaces 111-1 and 111-2, wherein the oxide layer on each on each of the deposition surfaces 111-1 and 111-2 has a thickness of 500 Angstroms or less. In another implementation, the bonding layer of oxide formed on one or both of the deposition surfaces 111-1 and 111-2 has a thickness of less than 200 Angstroms. In yet another implementation, the bonding layer formed on each deposition surfaces 111-1 and 111-2 has a thickness of 100 Angstroms. In still another implementation, bonding layer 121 is formed only on deposition surface 111-1 and has a thickness of 100 Angstroms, and no bonding layer is formed on deposition surface 111-2.

In one implementation, the bonding layer of oxide is formed using a chemical vapor deposition process that may include plasma enhanced vapor deposition (PECVD) or tetraethyl orthosilicate (TEOS) deposition. In another implementation, the bonding layer of oxide is formed using a physical vapor deposition process such as sputtered deposition. In yet another implementation, the bonding layer of oxide is grown using a thermal oxidation process. In some implementations, oxide provided to form the bonding layer is provided at a temperature equal to or less than 325° Celsius. Bonding layers 121-1 and 121-2 have intrinsically smooth bonding surfaces 131-1 and 131-2 as depicted in Figure 1B. Bonding surfaces 131-1 and 131-2 are smooth at an atomic lateral scale of less than 0.3 nanometers RMS roughness. As stated above, in some implementations, bonding layer 121-1 is formed only on deposition surface 111-1 and no bonding layer is formed on deposition surface 111-2. In such an implementation, deposition surface 111-2 is also bonding surface 131-2.

After providing oxide to form a bonding layer, the wafers are soaked in a solution that makes the bonding surfaces hydrophilic. This solution may comprise a combination of water with one or more of an acid, a base, or an oxidizer. This step could be performed using a standard RCA cleaning process. In the exemplary method shown in Figure 2, block 204 comprises soaking the wafers in a solution of water, hydrogen peroxide and ammonium hydroxide. In one implementation, the wafers are soaked for at least 10 minutes in a 5:1:0.2 solution of water, hydrogen peroxide and ammonium hydroxide that is heated to a temperature of at least 70 degrees Celsius. In other implementations, the soak time, the ratio of water to hydrogen peroxide to ammonium hydroxide, and the temperature of the solution can vary. The soak causes bonding surfaces 131-1 and 131-2 to be terminated with a monolayer of hydroxide (OH) 141-1 and 141-2, shown in Figure 1C, that allows the wafers to stick together spontaneously. The process then comprises rinsing each wafer with water (block 206) and drying the wafers (block 208).

The next step of the process is depicted in Figure ID comprising bonding the wafers with each other (block 210). Because the bonding layer 121-1 and 121-2 provide intrinsically smooth surfaces 131-1 and 131-2, the wafers can be bonded using the process of optical contact bonding by bringing bonding surfaces 131-1 and 131-2 in contact with each other. After the RCA cleaning has been performed, the bonding surface 121-1 and 121-2 is terminated with hydroxide (OH) forming monolayers 141-1 and 141-2 that allow the bond to occur spontaneously. The intermolecular forces after the soak draw the two wafers to stick spontaneously through optical contact bonding. The wafers can be bonded by putting the wafers through an alignment machine. Alternatively, the wafers can also be bonded manually by aligning the flat sections on each wafer and folding the two wafers together. Manual bonding of the wafers may require some pressure to be applied.

The final step in the process is annealing the bonded wafer pair at temperature less than 500° Celsius (block 212). In one implementation, annealing the bonded wafers comprises baking the bonded pair at a temperature greater than or equal to 150° Celsius for at least three hours. In other implementations, the temperature and duration of annealing can vary. As depicted in Figure 1E, in some implementations, once the pair is annealed, the two layers of oxide 121-1 and 121-2 fuse together to form a single interface layer 151. The interface layer 151 comprises 100 Angstroms to 1000 Angstroms of oxide. In a further implementation, the interface layer comprises less than or equal to 400 Angstroms of oxide. In yet another implementation, the interface layer comprises 200 Angstroms of oxide.

Figure 1E depicts the structure with the low temperature wafer to wafer bond formed. This structure can be used in various technologies including applications in microelectronics, accelerometers, gyroscopes, or pressure sensors. As shown in Figure IE, an interface layer is bonded to two layers 101-1 and 101-2. In some implementations, layers 101-1 and 101-2 are wafers. In some implementations, layer 101-1 and layer 101-2 are composed of different materials (ex. silicon to sapphire bond). In other implementations, layer 101-1 and 101-2 are composed of the same material. For example, in one implementation, the structure has a first wafer layer 101-1 and a second wafer layer 101-2 composed of silicon. The structure of Figure IE has an interface layer 151 composed of oxide with a thickness T ranging from 100 to 1000 Angstroms inclusive. As depicted in Figure IE, the interface layer is provided between the first wafer layer 101-1 and the second wafer layer 101-2.

Interface layer 151 is provided between the first wafer layer 101-1 and the second wafer layer 101-2. As shown in the example of Figure 1E, a thin layer of oxide is provided on at least one of the first wafer layer and the second wafer layer to form the interface layer when the first wafer layer 101-1 and second wafer layer 101-2 are bonded together. In some implementations, a thin oxide layer is provided on the first wafer layer and the second wafer layer to form the interface layer 151.

In some implementations, the interface layer further comprises a first oxide layer and a second oxide layer, wherein the first oxide layer is bonded to the first wafer layer and the second oxide layer is bonded to the second wafer layer. In a further implementation, the bond between the first oxide layer and the first wafer layer and the bond between the second oxide layer and the second wafer layer is stronger than the bond between the first oxide layer and the second oxide layer. In another implementation, the bond between the first wafer layer and the interface layer is stronger than the bond between the interface layer and the second wafer layer. In some implementations, the interface layer comprises silicon oxide.

In one implementation, the strength of the low temperature bond is at least 2.5 J/m². Further, in some exemplary structures, the low temperature bond is hermetic. In some implementations, the interface layer 151 has a thickness T that is less than or equal to 400 Angstroms. In a further implementation, the strength of the low temperature bond is in a range of 3.15 J/m² to 3.61 J/m².

### EXAMPLE EMBODIMENTS

Example 1 includes a method of low temperature wafer bonding, the method comprising: providing oxide to form a bonding layer on a deposition surface of at least one of two wafers, the bonding layer having a thickness in the range of 100 Angstroms to 500 Angstroms; soaking the wafers in a solution that makes bonding surfaces of the wafers hydrophilic; rinsing the wafers with water after soaking the wafers in the solution; drying the wafers; optical-contact bonding the wafers with each other by bringing the bonding surfaces of the two wafers in contact with each other to form a wafer pair; and annealing the wafer pair at a temperature less than or equal to 500° Celsius.
Example 2 includes the method of Example 1, wherein one or both the wafers used for low temperature wafer bonding are composed of silicon.
Example 3 includes the method of any of Examples 1-2, wherein the oxide to form a bonding layer is silicon oxide.
Example 4 includes the method of any of Examples 1-3, wherein providing oxide to form a bonding layer on a deposition surface of at least one of two wafers further comprises forming an oxide layer with thickness of 500 Angstroms or less on each of the two wafers.
Example 5 includes the method of any of Examples 1-4, wherein providing oxide to form a bonding layer on a deposition surface of at least one of two wafers further comprises forming an oxide layer on one or both respective bonding surfaces of the wafers with a thickness of less than 200 Angstroms.
Example 6 includes the method of any of Examples 1-5, wherein providing oxide to a bonding layer on a deposition surface of at least one of two wafers further comprises using a chemical vapor deposition process such as plasma enhanced chemical vapor deposition (PECVD) or tetraethyl orthosilicate (TEOS).
Example 7 includes the method of any of Examples 1-6, wherein providing oxide to form a bonding layer on a deposition surface of at least one of two wafers comprises depositing oxide at a temperature equal to or less than 325 degrees Celsius on one or both respective bonding surfaces of the wafers.
Example 8 includes the method of any of Examples 1-7, wherein providing oxide to form a bonding layer on a deposition surface of at least one of two wafers further comprises using a physical vapor deposition process such as sputtered deposition.
Example 9 includes the method of any of Examples 1-8, wherein providing oxide to form a bonding layer on a deposition surface of at least one of two wafers further comprises using a process of thermal oxidation.
Example 10 includes the method of any of Examples 1-9, wherein annealing the bonded wafer pair further comprises baking the bonded wafer pair at a temperature greater than or equal to 150° Celsius for at least three hours.
Example 11 includes the method of any of Examples 1-10, wherein optical-contact bonding the wafers with each other further comprises putting the wafers through an alignment machine.
Example 12 includes the method of any of Examples 1-11, wherein both the wafers used for low temperature wafer bonding are composed of the same material.
Example 13 includes a structure with a low temperature bond, the structure comprising: a first wafer layer; a second wafer layer; and an interface layer provided between the first layer and the second layer, wherein a thin layer of oxide is provided on at least one of the first wafer layer and the second wafer layer to form the interface layer when the first wafer layer and the second wafer layer are bonded together, and wherein the interface layer has a thickness in the range of 100 Angstroms to 1000 Angstroms.
Example 14 includes the structure of Example 13, wherein a thin layer of oxide is provided on both the first wafer layer and the second wafer layer to form the interface layer.
Example 15 includes the structure of any of Examples 13-14, wherein the first wafer layer is composed of the same material as the second wafer layer.
Example 16 includes the structure of any of Examples 13-15, wherein at least one of the first wafer layer and the second wafer layer is composed of silicon.
Example 17 includes the structure of any of Examples 13-16, wherein strength of the low temperature layer bond is at least 2.5 J/m².
Example 18 includes the structure of any of Examples 13-17, wherein the oxide provided in the interface layer is silicon oxide.
Example 19 includes the structure of any of Examples 13-18, wherein the bond between the first wafer layer and the second wafer layer is hermetic.
Example 20 includes a method of low temperature hermetic silicon to silicon bond, the method comprising: depositing plasma enhanced chemical vapor deposition (PECVD) silicon oxide on a first bonding surface of a first silicon wafer at a temperature less than 500 degrees Celsius to form a first oxide layer with a thickness in a range of 100 to 500 Angstroms; soaking the first silicon wafer and a second silicon wafer in a solution of 5:1: 0.2 ratio of water, hydrogen peroxide and ammonium hydroxide solution; rinsing the first and the second silicon wafers with water; drying the first and the second silicon wafers; optical-contact bonding the first and the second silicon wafers with each other to form a silicon wafer pair; and annealing the silicon wafer pair at a temperature of less than 500 degrees Celsius.

Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the claims and the equivalents thereof.

## Claims

1. A method of low temperature wafer bonding, the method comprising:
providing oxide to form a bonding layer on a deposition surface of at least one of two wafers, the bonding layer having a thickness in the range of 100 Angstroms to 500 Angstroms;
soaking the wafers in a solution that makes bonding surfaces of the wafers hydrophilic;
rinsing the wafers with water after soaking the wafers in the solution;
drying the wafers;
optical-contact bonding the wafers with each other by bringing the bonding surfaces of the two wafers in contact with each other to form a wafer pair; and
annealing the wafer pair at a temperature less than or equal to 500° Celsius.

2. The method of claim 1, wherein one or both the wafers used for low temperature wafer bonding are composed of silicon.

3. The method of claim 1, wherein the oxide to form a bonding layer is silicon oxide.

4. The method of claim 1, wherein providing oxide to form a bonding layer on a deposition surface of at least one of two wafers further comprises forming an oxide layer with thickness of 500 Angstroms or less on each of the two wafers.

5. The method of claim 1, wherein providing oxide to a bonding layer on a deposition surface of at least one of two wafers further comprises using a chemical vapor deposition process such as plasma enhanced chemical vapor deposition (PECVD) or tetraethylorthosicillate (TEOS).

6. The method of claim 1, wherein providing oxide to form a bonding layer on a deposition surface of at least one of two wafers further comprises using a physical vapor deposition process such as sputtered deposition.

7. The method of claim 1, wherein providing oxide to form a bonding layer on a deposition surface of at least one of two wafers further comprises using a process of thermal oxidation.

8. A structure with a low temperature bond, the structure comprising:
a first wafer layer;
a second wafer layer; and
an interface layer provided between the first layer and the second layer, wherein a thin layer of oxide is provided on at least one of the first wafer layer and the second wafer layer to form the interface layer when the first wafer layer and the second wafer layer are bonded together, and wherein the interface layer has a thickness in the range of 100 Angstroms to 1000 Angstroms.

9. The structure of claim 8, wherein the first wafer layer is composed of the same material as the second wafer layer.

10. The structure of claim 8, wherein strength of the low temperature bond is at least 2.5 J/m².
